# EUROPEAN PATENT APPLICATION

(11) **EP 3 828 820 A1**
(43) Date of publication of application: **02.06.2021**
(21) Application number: 20208953.8
(22) Date of filing: 20.11.2020
(51) Int. Cl.: G06T 7/00, H05K 13/08

(54) **AI BASED AUTOMATIC JUDGMENT UNIT FOR QUALITY CLASSIFICATION OF SEMIFINISHED COMPONENT CARRIERS OF A PANEL BASED ON AUTOMATIC OPTICAL INSPECTION**

(30) Priority: 27.11.2019 CN 201911181242
(71) Applicant: AT&S (Chongqing) Company Limited, Chongqing 401133 (CN)
(72) Inventor: Tay, Seok Kim, Singapore 128807 (SG); Shi, Teoh Zhen, 76450 Melaka (MY); Zhang, Jinwang, Chongqing, Chongqing (CN)
(74) Representative: Dilg, Haeusler, Schindelmann Patentanwaltsgesellschaft mbH

(57) **Abstract**

A method of manufacturing component carriers (100), wherein the method comprises supplying a panel (102), comprising a plurality of semifinished component carriers (100), to an automatic optical inspection unit (104) for automatic optical inspection by comparison of a data set indicative of an actual image of a respective semifinished component carrier (100) with a data set indicative of a reference image, forwarding the inspected panel (102) to an automatic judgment unit (106) for carrying out a quality classification of the semifinished component carriers (100), based on a result of the automatic optical inspection, by applying artificial intelligence, and taking an action based on the quality classification.

## Description

The invention relates to a method of manufacturing component carriers, an apparatus for handling a panel during manufacturing component carriers, a computer-readable medium, and a program element.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

Quality classification of semifinished component carriers on panel level during manufacture is conventionally carried out by human operators. However, the quality classification by human operators is cumbersome and prone to failure.

It is an object of the invention to process semifinished component carriers on panel level with high yield and reasonable effort.

In order to achieve the object defined above, a method of manufacturing component carriers, an apparatus for optical inspection of component carriers of a panel during manufacturing component carriers, a computer-readable medium, and a program element according to the independent claims are provided.

According to an exemplary embodiment of the invention, a method of manufacturing component carriers is provided, wherein the method comprises supplying a panel, comprising a plurality of semifinished component carriers, to an automatic optical inspection unit for automatic optical inspection by comparison of a data set indicative of an actual image of a respective semifinished component carrier with a data set indicative of a reference image, forwarding the inspected panel to an automatic judgment unit for carrying out a quality classification of the semifinished component carriers, based on a result of the automatic optical inspection, by applying artificial intelligence, and taking an action based on the quality classification.

According to another exemplary embodiment of the invention, an apparatus for handling a panel during manufacturing component carriers is provided, wherein the apparatus comprises an automatic optical inspection unit configured for carrying out an automatic optical inspection of the panel, comprising a plurality of semifinished component carriers, by comparison of a data set indicative of an actual image of a respective semifinished component carrier with a data set indicative of a reference image, an automatic judgment unit configured for subsequently carrying out a quality classification of the semifinished component carriers, based on a result of the automatic optical inspection, by applying artificial intelligence, and an action control unit configured for taking an action based on the quality classification.

According to still another exemplary embodiment of the invention, a program element (for instance a software routine, in source code or in executable code) is provided, which, when being executed by a processor (such as a microprocessor or a CPU), is adapted to control or carry out a method having the above mentioned features.

According to yet another exemplary embodiment of the invention, a computer-readable medium (for instance a CD, a DVD, a USB stick, an SD card, a floppy disk or a hard disk, or any other (in particular also smaller) storage medium) is provided, in which a computer program is stored which, when being executed by a processor (such as a microprocessor or a CPU), is adapted to control or carry out a method having the above mentioned features.

Data processing which may be performed according to embodiments of the invention can be realized by a computer program, that is by software, or by using one or more special electronic optimization circuits, that is in hardware, or in hybrid form, that is by means of software components and hardware components.

In the context of the present application, the term "component carrier" may particularly denote any support structure which is capable of accommodating one or more components thereon and/or therein for providing mechanical support and/or electrical connectivity and/or optical connectivity and/or thermal connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above-mentioned types of component carriers.

In the context of the present application, the term "panel" may particularly denote a preform of still integrally connected component carriers as obtained during manufacturing component carriers in a batch procedure. For example, such a panel may comprise a plurality of preforms of component carriers which still form an integral structure, and which may be arranged in rows and columns. It is also possible that the component carriers of a panel are arranged in arrays, for instance each comprising six component carriers. For example, such a panel may have a dimension of 18 x 12 square inch or 18 x 24 square inch.

In the context of the present application, the term "automatic optical inspection" may particularly denote an optical monitoring system capturing images of panels or individual semifinished component carriers thereof and inspecting as to whether specific properties of a respective semifinished component carrier are in accordance with target properties. For this purpose, the automatic inspection unit, which may function independent from human operators, may capture a data set indicative of an image of a semifinished component carrier or panel to be inspected, i.e. a data set indicative of its actual image. Said actual image data may then be compared with a data set indicative of a reference image or target image, i.e. a data set of parameters indicating how the semifinished component carrier or panel should look like to meet a specific specification. A result of such an automatic optical inspection may be that the semifinished component carrier or panel passes the automatic inspection test or fails the automatic inspection test.

In the context of the present application, the term "automatic judgement unit" may particularly denote a device, which may operate automatically and thus independently of a human operator, which classifies a semifinished component carrier or panel under test into one of a plurality of different classes. The classification may hereby be carried out on the basis of the result of the previous automatic optical inspection.

In the context of the present application, the term "taking an action" may particularly denote that a certain procedure may be carried out which can be selected from a number of possible actions. The decision which action is to be taken can be made on the basis of the result of the quality classification of the automatic judgement unit.

In the context of the present application, the term "artificial intelligence" may particularly denote tools such as neural networks, self-learning or self-adaptive systems, fuzzy logic, etc. Artificial intelligence may operate independently of human beings on the basis of electronic hardware and software resources.

In the context of the present application, the term "comparison of a data set indicative of an actual image with a data set indicative of a reference image" may particularly denote that, as an image may be defined by gathered data, various parameters and/or measurements deducted from the images or pictures may be compared. It may however also be possible to compare the images or pictures itself or the pixels thereof.

According to an exemplary embodiment of the invention, a system of quality control of semifinished component carriers being still integrally connected on panel level is provided, which can be carried out in a fully automatic way and without human operators. While it has been conventionally assumed that such a quality control cannot be carried out without the specific skills of human operators, the present inventors have surprisingly found that a part of the quality control, which has conventionally been carried out by human operators only, i.e. judgement of the validity or invalidity of a result of an automatic optical inspection, can be automated by involving elements of artificial intelligence. It has been found that, when such a system of artificial intelligence has been trained for a sufficiently long time with corresponding data (in particular a sufficient number of human based judgements as to whether a previous automatic optical inspection result is correct or not), it can reliably carry out a judgement as to whether a result of an automatic optical inspection is to be confirmed, refused and overruled, or whether additional analysis is required for a sufficiently reliable judgement. By taking this measure, the yield of a component carrier manufacturing process may be improved, and the component carrier manufacturing process may be rendered quicker and more accurate.

In the following, further exemplary embodiments of the method, the apparatus, the computer-readable medium, and the program element will be explained.

In an embodiment, the method comprises taking the action of continuing manufacturing the component carriers without intervening process steps or without intervention, i.e. doing nothing special. Taking the decision that no specific procedure needs to be executed involves a very low effort in the component carrier manufacturing process in terms of quality control. In other words, if the automatic judgement unit comes to the conclusion that no specific action needs to be taken, the component carrier manufacturing procedure simply proceeds, for instance with a singularization of the individual semifinished component carriers from the panel. For instance, the lack of intervening process steps may relate to taking no extraordinary action or measure, but proceeding with a standard or predefined default process flow. Continuation of processing may occur without intervening process steps, without human intervention, without human intervention in case of no faults, etc.

In an embodiment, the method comprises taking the action of continuing manufacturing the component carriers without intervention when the quality classification indicates no defect of a respective semifinished component carrier. Thus, when the automatic judgement unit comes to the conclusion that a specific component carrier has no defect, no specific action needs to be taken apart from the continuation of the ordinary manufacturing process.

In an embodiment, the method may also comprise taking the action of continuing manufacturing the component carriers without intervention when the quality classification indicates an unrepairable defect of a respective semifinished component carrier. Hence, classifying a specific component carrier as non-repairable, since for instance a defect has been identified which cannot be repaired or cannot be repaired with reasonable effort, may make the system consider said component carrier as a final fail. The manufacturing method of the remaining semifinished component carriers of the panel may simply continue, and the unrepairable semifinished component carrier will not be used at the end of the manufacturing process.

In an embodiment, the method comprises taking the action of repairing a respective semifinished component carrier when the quality classification indicates a repairable defect of a respective semifinished component carrier. Thus, the automatic judgement unit may send a semifinished component carrier of a panel to a repair process when determining or judging that there is a defect of a semifinished component carrier or entire panel which is however of such a nature that it can be repaired by an automatic repair process or by a human operator. By taking this measure, the yield of the component carrier manufacturing process may be improved. When a reparable defect is identified by the automatic judgement unit, said semifinished component carrier is classified correspondingly and a repair of the same may be carried out. After a successful repair, the classification of said semifinished component carrier may be changed from fail to pass.

In an embodiment, the repairing comprises at least one of the group consisting of separation of erroneously connected traces, connection of erroneously separate traces, repair of an erroneous solder structure, and repair of an erroneous core. For example, electrically conductive traces of a semifinished component carrier which are erroneously connected may be separated by a laser or a cutting blade which can be operated automatically or under control of a human operator. Also, an undesired separation of different traces of a semifinished component carrier may be repaired by connecting them, for instance by putting a solder spot or any electrically conductive paste to a portion where two traces are erroneously disconnected. When for instance a solder structure is simply missing or has an erroneously small volume, additional solder material may be applied to said specific defect portion by a human operator or automatically. Even when a core, i.e. a fully cured plate shaped central structure of a semifinished component carrier, has been identified, it may be repaired to avoid loss of an entire component carrier. This allows using resources more efficiently and keeping the footprint as small as possible. The repair procedure can be carried out automatically or by a human operator.

In an embodiment, the method comprises taking the action of repairing a respective semifinished component carrier on basis of a data set indicative of a three-dimensional image of the semifinished component carrier or the panel. Highly advantageously, carrying out the repair may be done after having captured a three-dimensional image at least of the portion of a component carrier to be repaired. For example, the automatic optical inspection may be made on the basis of a two-dimensional image of the component carrier or panel. However, in order to ensure that the repair is carried out correctly and accurately, an additional three-dimensional image may be captured before initiating the repair.

In an embodiment, the method comprises carrying out the quality classification to classify a respective individual semifinished component carrier or an entire panel as "pass". In an embodiment, the method comprises carrying out the quality classification to classify a respective individual semifinished component carrier or an entire panel as "fail". In an embodiment, the method comprises carrying out the quality classification to classify a respective individual semifinished component carrier or an entire panel as "repairable" or "to be repaired". When the automatic judgement unit comes to the conclusion that the classification of a semifinished component carrier or panel as defective, made by the automatic inspection unit, is fully justified, it may confirm the classification as "fail". If the automatic judgement unit comes to the conclusion that a classification of a semifinished component carrier or panel made by the automatic optical inspection unit as "pass" is correct, the semifinished component carrier or panel is accepted. However, the automatic judgement unit may also overrule the automatic optical inspection unit and may change a classification from "pass" to "fail", or vice versa. For example, a deviation between a data set indicative of an actual image and a data set indicative of a target image as identified by the optical inspection unit may be correct as such but may have no impact on the functionality of the component carrier. In such an event, a component carrier classified as defective by the automatic inspection unit may nevertheless be classified as "pass" by the automatic judgement unit. Artificial intelligence, which may emulate human experience, may particularly help for making such a meaningful decision in the automatic judgment unit.

In an embodiment, the method comprises carrying out the quality classification so as to indicate a type of defect among a number of predefined types of defect (for instance erroneous connection of traces, erroneous separation of traces, insufficient solder, etc.). Providing a list of frequent defects, from which an identified defect may be selected, may streamline the process of defect handling.

In an embodiment, the method is carried out completely without human operator. Thus, the apparatus and method may operate in a way that no human interference is necessary at all. It has turned out that, after a certain amount of learning cycles, the automatic judgement unit operating on the basis of artificial intelligence may take even better judgements than human operators. By taking this measure, the manufacturing process of the component carriers may be streamlined, and the throughput and yield may be improved.

In an embodiment, the method comprises carrying out the automatic optical inspection based on a data set indicative of a two-dimensional image of the entire panel or a respective individual semifinished component carrier. Thus, a simple image of a camera may be taken as actual image for comparison with a target or reference image. It has turned out as sufficient to do the comparison on the basis of the automatic inspection unit, which is nevertheless reviewed later by the automatic judgement unit, on this numerical simple basis involving only a comparison of features from two two-dimensional images. This also renders the automatic optical inspection process fast.

In an embodiment, the method comprises carrying out the automatic judgment based on a data set indicative of a three-dimensional image of the entire panel or a respective individual semifinished component carrier. Highly advantageously, the automatic optical inspection, which may be carried out on the basis of two-dimensional images of semifinished component carriers or panels, may be combined with an analysis made by the automatic judgement unit on the basis of a three-dimensional image. Therefore, the automatic inspection unit, which may carry out the final judgement on the basis of critical portions of respective component carriers only and having the power of overruling the results of the automatic optical inspection, may be carried out on the basis of a more refined three-dimensional image of such a critical portion. As a result, only a critical portion is assessed with higher computational burden so that the overall reliability can be rendered high and the effort involved with the combined optical inspection and judgement algorithm can be made accurate and reliable.

In an embodiment, the method comprises, in case the automatic judgment unit is incapable of performing quality classification, carrying out a further analysis. It may even happen, although the automatic judgement unit operates on the basis of artificial intelligence, that certain semifinished component carriers cannot be reliably classified by the automatic judgement unit. In such an event, corresponding semifinished component carriers or panels may be temporarily channelled out the manufacturing process and may be made subject to individual judgement, for instance by a human operator or preferably by additional automatic analysis.

In an embodiment, the method comprises carrying out the further analysis by an additional automatic judgment unit applying artificial intelligence. Thus, it is possible that also the second or further analysis is carried out by a system operating on the basis of artificial intelligence, for instance a higher level of artificial intelligence functionality. Hence, limited to the cases which are considered as critical by the first artificial intelligence system, a more refined second artificial intelligence system may be involved.

In an embodiment, the method comprises exchanging data between the automatic judgment unit and the additional automatic judgment unit for learning, in particular in forward direction (i.e. sending data from the automatic judgment unit to the additional automatic judgment unit) and/or backward direction (i.e. sending data from the additional automatic judgment unit to the automatic judgment unit). By exchanging data between the two systems involving artificial intelligence, the decision making of both systems may be further improved. For instance, when being overruled by the second system of artificial intelligence (i.e. by the additional automatic judgment unit), the first system of artificial intelligence (i.e. the automatic judgment unit) may take such an overruling into account for adapting its weights and for considering this for future judgements. It is also possible that a decision which is exceptionally made by a human operator in such critical scenarios will be used for adapting the weights of a neural network or for self-adaptive learning of a respective one of the two automatic judgment unit.

In an embodiment, the method comprises carrying out the further analysis by the additional automatic judgment unit based on a data set indicative of a three-dimensional image of a respective individual semifinished component carrier or the entire panel. When said additional analysis is made on the basis of a three-dimensional image rather than on the basis of a two-dimensional image only, the data basis for taking a meaningful decision may be further broadened.

In an embodiment, the method comprises applying the artificial intelligence by learning based on historical human-based judgments, in particular under consideration of a comparison of judgments proposed by the automatic judgment unit with human-based judgments. Hence, learning on the basis of a sufficiently high number of decision taken by human operators (in particular 1000 cases, more particularly at least 10000 cases) allows to adjust the weights of a self-adaptive or self-learning system in such a way that, for future decisions, the performance of an automatic judgement can be made at least as reliable as that of a human being.

In an embodiment, the method comprises marking, in particular laser marking, a respective semifinished component carrier or an entire panel based on the results of the quality classification. After having made the automatic inspection and the automatic judgement, a corresponding semifinished component carrier or panel may be marked in accordance with the result of this classification as a basis for a subsequent handling. For instance, a cross may be marked on a respective semifinished component carrier or panel. This can be done for instance by laser processing. By marking a semifinished component carrier or panel with a corresponding mark allows providing a physical identifier allowing to identify erroneously manufactured component carriers quickly and highly reliable.

In an embodiment, the method comprises carrying out the automatic optical inspection during front-end processing. In the context of the present application, the term "front-end processing" may particularly denote a processing of the panels before separation into arrays. In particular, an interface between front-end and back-end processing may be formation of a solder mask or a surface finish process. Back-end processing may process semifinished component carriers on array level rather than on panel level. It has been found that during front-end processing, a purely automatic optical inspection and purely automatic judgement as a basis for classification of the semifinished component carriers can be carried out with high reliability. The front-end is based on objective criteria when assessing the quality of a semifinished component carrier or panel and is therefore specifically appropriate for a purely automatic inspection system. Preferably, the method comprises carrying out the automatic optical inspection and the quality classification after patterning a metal layer for forming electrically conductive traces on the semifinished component carriers or the entire panel for assessing a quality of the traces. Thus, directly after such a patterning procedure, the success of the latter may be assessed by the automatic optical inspection followed by a quality classification in the front-end. In an embodiment, said procedure may be repeated for each patterned layer.

In an embodiment, the semifinished component carriers comprise a stack of at least one electrically insulating layer structure and at least one electrically conductive layer structure. In the context of the present application, the term "layer structure" may particularly denote a continuous layer, a patterned layer or a plurality of non-consecutive islands within a common plane. A layer structure may be electrically insulating and/or electrically conductive. For example, the component carriers may be a laminate of the mentioned electrically insulating layer structure(s) and electrically conductive layer structure(s), in particular formed by applying mechanical pressure and/or thermal energy. The mentioned stack may provide plate-shaped component carriers capable of providing a large mounting surface for further components and being nevertheless very thin and compact.

In an embodiment, the semifinished component carriers are shaped as a plate. This contributes to the compact design, wherein the component carriers nevertheless provide a large basis for mounting components thereon. Furthermore, in particular a naked die as example for an embedded electronic component, can be conveniently embedded, thanks to its small thickness, into a thin plate such as a printed circuit board. A plate-shaped component carrier also ensures short electric connection paths, and therefore suppresses signal distortion during transport.

In an embodiment, the component carriers formed on the basis of the panel is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Size Package (CSP)).More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive pass, whereas vertical connections may be for example drill holes. These lateral and/or vertical connections are arranged within the substrate and can be used to provide electrical and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) or a photoimageable or dry-etchable organic material like epoxy-based build-up material (such as epoxy-based build-up film) or polymer compounds like polyimide, polybenzoxazole, or benzocyclobutene.

In an embodiment, each of the above mentioned electrically insulating layer structures comprises at least one of the group consisting of resin (such as reinforced or non-reinforced resins, for instance epoxy resin or bismaleimide-triazine resin), cyanate ester, polyphenylene derivate, glass (in particular glass fibers, multi-layer glass, glass-like materials), prepreg material (such as FR-4 or FR-5), polyimide, polyamide, liquid crystal polymer (LCP), epoxy-based build-up film, polytetrafluoroethylene (Teflon), a ceramic, and a metal oxide. Reinforcing materials such as webs, fibers or spheres, for example made of glass (multilayer glass) may be used as well. Although prepreg particularly FR4 are usually preferred for rigid PCBs, other materials in particular epoxy-based build-up film for substrates may be used as well. For high frequency applications, high-frequency materials such as polytetrafluoroethylene, liquid crystal polymer and/or cyanate ester resins, low temperature cofired ceramics (LTCC) or other low, very low or ultra-low DK materials may be implemented in the component carrier as electrically insulating layer structure.

In an embodiment, each of the above mentioned electrically conductive layer structures comprises at least one of the group consisting of copper, aluminum, nickel, silver, gold, palladium, and tungsten. Although copper is usually preferred, other materials or coated versions thereof are possible as well, in particular coated with supra-conductive material such as graphene.

In an embodiment, the semifinished component carrier further comprises an electronic component mounted on and/or embedded in the component carrier material, in particular in the stack. For instance, the electronic component may be a radiofrequency semiconductor chip configured for emitting and/or receiving radiofrequency signals via the wiring structures and being electrically coupled with the electrically conductive wiring structures. Hence, the electronic component may be configured for executing a radio frequency application, in particular a radio frequency application involving frequencies above 1 GHz.

At least one component may be surface mounted on and/or embedded in the component carrier and can in particular be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an optical element (for instance a lens), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a substrate, an interposer or a further component carrier, for example in a board-in-board configuration. The component may be surface mounted on the component carrier and/or may be embedded in an interior thereof.

In an embodiment, the component carriers are laminate-type component carriers. In such an embodiment, the component carrier is a compound of multiple layer structures which are stacked and connected together by applying a pressing force and/or heat.

After processing interior layer structures of the semifinished component carriers, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such as solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), gold (in particular Hard Gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates an apparatus for handling panels during manufacturing component carriers according to an exemplary embodiment of the invention.
Figure 2 illustrates a flowchart of a semiautomatic method of manufacturing component carriers according to an exemplary embodiment of the invention.
Figure 3 illustrates a flowchart of a fully automatic method of manufacturing component carriers according to an exemplary embodiment of the invention.

The illustrations in the drawings are schematic. In different drawings, similar or identical elements are provided with the same reference signs.

Before referring to the drawings, exemplary embodiments will be described in further detail, some basic considerations will be summarized based on which exemplary embodiments of the invention have been developed.

According to an exemplary embodiment of the invention, a smart automatic optical inspection and automatic judgement system for manufacturing component carriers may be provided, which may also involve a decision making concerning the necessity of repairing defective semifinished component carriers or panels. In an embodiment, an artificial intelligence working station may be applied to filter defects identified by an automatic optical inspection unit. This may improve quality and may remove manually occurring errors without manual handling by human operators. Such a system may also allow obtaining a better efficiency, in particular a shorter process flow and cycle time. Moreover, head count and machine quantity may be reduced so as to improve the efficiency of manufacturing component carriers.

In a preferred embodiment, a component carrier or panel may be inspected by an automatic optical inspecting unit to obtain defect data. This may be done by comparing a data set indicative of an actual image of such a semifinished component carrier or panel with a data set indicative of a target or reference image stored in a database. As a next procedure, the semifinished component carrier or panel may be forwarded to an automatic judgement unit which may carry out a judgement of the validity or invalidity of a decision made during automatic optical inspection. As a result of this judgement, an automated optical repair and/or automated optical shaping procedure may be carried out directly, in particular without any manual handling. At the same time, defect data may be transferred to an artificial working station forming part of the automatic judgement unit. Here, actually defective component carriers or panels may be filtered out. The filtered data may be forwarded or used for automated optical repair. During automated optical repair, the data may be verified by catching different images of the component carrier or panel and may then be passed to a second artificial intelligence working station. The second artificial intelligence working station may filter the false defect (for instance classified erroneously as defective, while in fact being intact) semifinished component carriers or panels and may decide how to proceed. Possibilities of proceeding may be in particular shaping, scrapping or the need to verify again. Exemplary embodiments of the invention may be implemented as a full artificial intelligence process or alternatively as a semi-artificial intelligence-based process for quality assessment of semifinished component carriers or panels.

Advantageously, any mechanical handling of the semifinished component carriers or panels by human operators may become dispensable. Implementing the above-described artificial intelligence working station may reduce the defect quantity for verification. As a result, a fast and reliable automatic optical inspection process flow may be obtained with a full or at least partial automation. This may increase quality and efficiency. Required machine quantity can be reduced. The manufacturing process can be sped up. By obtaining fewer errors (caused by manual classification in conventional systems), the yield may be improved.

Thus, in particular upstream of back-end processes, i.e. in the front-end before carrying out a solder mask process or a surface finish process, a quality assessment of a semifinished component carrier or panel may be carried out, for instance for each layer thereof. For example, after a copper foil patterning process of a respective layer, it can be checked whether the copper patterning process has been carried out correctly. In this context, the quality of a respective component carrier or preform thereof may be assessed and, if it has been found to be potentially defective, a judgement may be made whether this preliminary classification has been correct and, if appropriate, a repair mechanism may be triggered. For instance, when two traces are erroneously connected, they may be separated during repair.

A gist of an exemplary embodiment of the invention is an artificial intelligence-based judgement of defects in front-end patterning. In this context, PCB (printed circuit board) related bodies such as semifinished component carriers, array or panels may be inspected. A comparison may be made between a data set indicative of an actual image of such a PCB related body and a data set indicative of a reference image of a PCB related body meeting a specific specification. Then, artificial intelligence may be implemented in an automatic judgement unit for comparing a classification of the semifinished component carriers or the panels on the basis of the previously carried out optical inspection. Then, an action may be taken based on the classification which has been carried out.

According to an exemplary embodiment of the invention, a smart automatic optical inspection may be combined with a repair system. Advantageously, this may ensure that no manual handing process is necessary in embodiments of the invention. Furthermore, it may be advantageously possible to apply an artificial intelligence working station to reduce the defect quantity for verification. This may guarantee a short, fast and smart automatic optical inspection process flow. Advantageously, this may enable a full automation process, with improved quality and reduced effort in terms of handling. Furthermore, the hardware and manpower effort may thus be reduced significantly. Moreover, the process flow and process time may be reduced, and the efficiency may thus be increased. Less manual error may occur, so that also the excursion may be reduced. Less copper comprising chips without manual scrap may be obtained, which may improve the yield. In particular for producing modules, the described manufacturing method may be in particular suitable (for instance to achieve a thinner thickness, a fine line to space ratio, more cards per array, etc.). Descriptively speaking, a smart working station with a proper filter function may be provided. Furthermore, it may be possible to target specifically on reducing the defects and to identify them automatically.

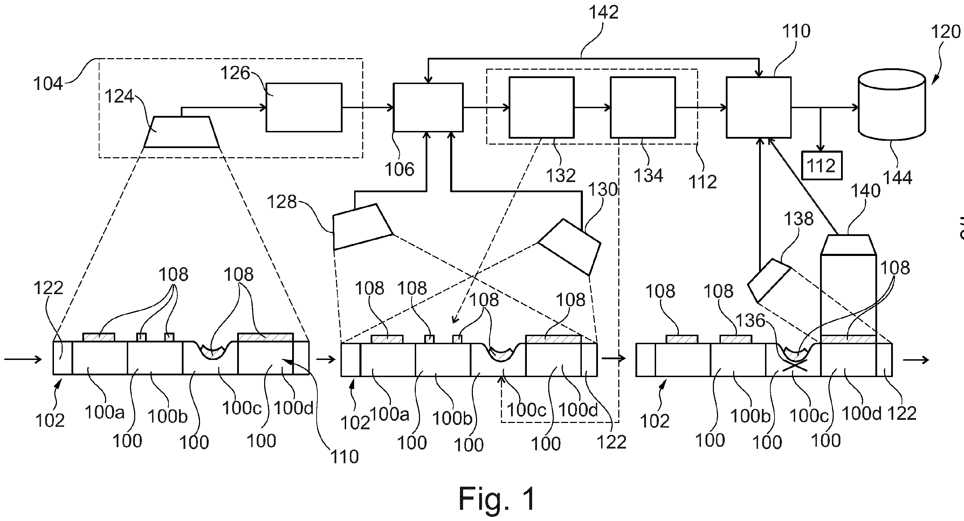

**Figure 1** illustrates an apparatus 120 for handling a panel 102 during manufacturing component carriers 100 according to an exemplary embodiment of the invention.

Figure 1 shows apparatus 120 for carrying out optical inspection and quality classification of semifinished component carriers 100 of panel 102 during manufacturing said component carriers 100. The apparatus 120 comprises an automatic optical inspection unit 104 configured for automatic optical inspection of the panel 102 by comparison of a data set indicative of an actual image of a respective semifinished component carrier 100 with a data set indicative of a reference image. Furthermore, the apparatus 100 comprises an automatic judgment unit 106 configured for subsequently carrying out a quality classification based on a result of the automatic optical inspection. For this purpose, the automatic judgment unit 106 may apply artificial intelligence. An action control unit 112 is provided for taking an action in accordance with a result of the quality classification. During operation of the apparatus 100, panel 102 with multiple semifinished component carriers 100 being still integrally connected on panel level may be supplied to the automatic optical inspection unit 104 for automatic optical inspection. This automatic optical inspection may be done based on a comparison of a data set indicative of an actual image of a respective semifinished component carrier 100 with a data set indicative of a reference image. Thereafter, it is possible to forward the inspected panel 102 to automatic judgment unit 106 for carrying out a quality classification based on a result of the automatic optical inspection by applying artificial intelligence. Thereafter, an action may be taken based on the quality classification, when this action may be defined by the action control unit 112.

In one embodiment, the taken action may be to simply continue the manufacturing process, i.e. to take no specific action deviating from the work-flow, when the quality classification indicates no defect of a respective semifinished component carrier 100 or indicates an unrepairable defect of a respective semifinished component carrier 100. The action to be taken may be to repair a respective semifinished component carrier 100 when the latter has been classified as defective, but repairable. For instance, the repairing may comprise separating erroneously connected traces 108, connecting erroneously separate traces 108, repairing an erroneous solder structure (not shown) and/or an erroneous core 110, etc. In an embodiment, it may be possible to take the action of repairing a respective semifinished component carrier 100 on basis of a data set indicative of a three-dimensional image of the semifinished component carrier 100 or the panel 102.

Now referring to the various options for the quality classification, it may be possible to carry out the quality classification to classify a respective individual semifinished component carrier 100 or an entire panel 102 as "pass". Alternatively, it is possible to carry out the quality classification to classify a respective individual semifinished component carrier 100 or an entire panel 102 as "fail". It may however also be possible to carry out the quality classification to classify a respective individual semifinished component carrier 100 or an entire panel 102 as "repairable" or "to be repaired". In case of a defect, it may be advantageous to carry out the quality classification by indicating a type of defect among a number of predefined types of defect. Of course, the possible amount of such classification categories is unlimited and can be adjusted to a specific application. For instance, it can be reasonable to grade "repairable" into several subcategories.

In particular, it may be possible to carry out the described procedure completely without human operator. Alternatively, it is also possible to carry out the described procedure in a semiautomatic way which may involve for instance a human operator for making critical decisions. Optical inspection and at least the primary stage of quality classification may however always be made automatically.

Carrying out the automatic optical inspection may be performed based on a data set indicative of a two-dimensional image of the entire panel 102 or a respective individual semifinished component carrier 100. In particular, it may be possible to carry out the automatic judgment based on a three-dimensional image of the entire panel 102 or a respective individual semifinished component carrier 100. In case the automatic judgment unit 106 is incapable of performing quality classification (or cannot guarantee sufficient precision), it may also be possible to carry out a further analysis before making a quality classification. Carrying out the further analysis may be done by an additional automatic judgment unit 110 applying artificial intelligence, for instance on a higher level as compared to the artificial intelligence applied by automatic judgment unit 106. Exchanging data between the automatic judgment unit 106 and the additional automatic judgment unit 110 may be performed for learning in forward and/or backward direction (wherein learning in backward direction is preferred). Applying the artificial intelligence may be accomplished by learning based on historical human-based judgments, in particular under consideration of a comparison of judgments proposed by the automatic judgment unit 106 and/or by the additional automatic judgment unit 110 with human-based judgments. It may also be possible to carry out the further analysis based on a data set indicative of a three-dimensional image of a respective individual semifinished component carrier 100 or the entire panel 102.

It is also possible that the described procedure comprises laser marking of a respective semifinished component carrier 100 or an entire panel 102 based on the quality classification. For instance, defective semifinished component carriers 100 may be marked with a laser engraved cross.

Figure 1 shows a cross-sectional view of the panel 102 composed of various semifinished component carriers 100 being still integrally connected within a frame 122 of the panel 102. As can be taken from the illustration of the panel 102 on the left-hand side of Figure 1, a copper foil on a core 110 has just been patterned to thereby form electrically conductive copper traces 108 on the various semifinished component carriers 100.

In the automatic optical inspection unit 104, a two-dimensional camera 124 captures a two-dimensional actual image of the surface of the panel 102 and forwards said image data to a first processor 126. The first processor 126 compares the actual image data captured by two-dimensional camera 124 with two-dimensional reference image data stored in a database (not shown). The data concerning the reference image indicate how a surface of the panel 102 should look like if the manufacturing process would have been carried out to comply with a specification. In other words, the first processor 126 determines as to whether the panel 102 meets the specification or fails to meet the specification based on said comparison in the framework of the automatic optical inspection. For example, if panel 102 fails to meet the specification based on said comparison in the framework, a conductive short or open area on panel 102 may be repaired, for instance by a dedicated laser head.

The result of said automatic optical inspection is forwarded to the automatic judgement unit 106, which can be configured as a further processor. The automatic judgement unit 106 reviews, rechecks or filters the determination made by the automatic optical inspection unit 124. For this purpose, artificial intelligence tools are used by automatic judgement unit 106. Furthermore, it is optionally possible that one or more further cameras 128, 130 capture a data set indicative of a three-dimensional image of the surface of the panel 102 to be inspected, or of only part thereof. Thus, more refined image data can be consulted by automatic judgement unit 106 for deciding about the decision or proposal made by automatic optical inspection unit 104.

In the shown example, semifinished component carrier 100a has met the specification in the analysis made by automatic optical inspection unit 104. If desired, automatic judgement unit 106 may further analyse the semifinished component carrier 100a. Since in the present example, also the automatic judgement unit 106 comes to the conclusion that the semifinished component carrier 100a meets the specification, it can be classified as "pass", since it has passed successfully the automatic optical inspection. For semifinished component carrier 100b, the automatic optical inspection unit 104 has identified two separated traces 108 rather than one connected trace (as in the semifinished component carrier 100a), so that the automatic optical inspection unit 104 has classified the semifinished component carrier 100b as "fail". Reviewing this proposal or decision of the automatic optical inspection unit 104, the automatic judgement unit 106 may determine that the classification of the semifinished component 100b as "fail" may be correct as such (since it does not meet the specification), but may be repaired. In particular, the automatic judgement unit 106 may assess that repairing the semifinished component carrier 100b may be possible by connecting the two erroneously separate traces 108. As can be taken from reference numeral 132 illustrating a repair unit, the semifinished component carrier 100b may be repaired to connect the two erroneously separated traces 108 so as to establish one connected trace 108 in the semifinished component carrier 100b, as shown in the illustration of the panel 102 in the repaired state on the right-hand side of Figure 1. Furthermore, a semifinished component carrier 100c shows a significant indentation in core 110 and has therefore been indicated by automatic optical inspection unit 104 as defective. This decision of the automatic optical inspection unit 104 can also be reviewed by the automatic judgement unit 106. Analysing the artefact in the semifinished component carrier 100c by automatic judgement unit 106 under consideration of a data set indicative of three-dimensional image data captured by cameras 128, 130 can result in the judgement that the semifinished component carrier 100c is defective and non-repairable. As a result, the automatic judgement unit 106 may also indicate to a laser marking unit 134 that the semifinished component carrier 100c should be marked with a physical marker 136 as defective and non-repairable. In the shown embodiment, the physical marker 136 is a cross which is laser engraved in the semifinished component carrier 100c. Concerning to a semifinished component carrier 100d, the automatic optical inspection unit 104 has also identified a deviation between a target size and an actual size of the trace 108 on the exterior surface. Descriptively speaking, trace 108 is too large in the semifinished component carrier 100d so that the automatic optical inspection unit 104 consider semifinished component carrier 100d as "fail". This decision can be reviewed by automatic judgement unit 106, for instance on the basis of additional three-dimensional image data captured by cameras 128, 130 of the respective surface of the semifinished component carrier 100d. When analysing the image captured from the surface of the semifinished component carrier 100d, the automatic judgement unit 106 may determine that, although the trace 108 is in fact too large to match with reference image data, it does not contact erroneously any other trace and therefore does not negatively influence the performance of the semifinished component carrier 100d. In this case, the automatic judgement unit 106 may overrule the decision of the automatic optical inspection unit 104 and may classify the semifinished component carrier 100d nevertheless as "pass".

As will be understood by a person skilled in the art, the blocks illustrated with reference numerals 132,134 do not need to be one after the other in the process flow. It may also be possible to omit one or both of them.

If desired, an additional automatic judgement unit 110, which may also implement artificial intelligence and which may comprise at least one processor, may be provided. For instance, it is also possible that the automatic judgement unit 106 comes to the conclusion that the semifinished component carrier 100d with the excessively large trace 108 is a borderline case and that it is doubtful whether the semifinished component carrier 100d should be classified as pass, fail or repair. In such an event, it is possible that a further three-dimensional camera composed of additional camera elements 138, 140 captures a detailed image of the semifinished component carrier 100d for a refined analysis of its classification. The additional automatic judgement unit 110, based on this additional analysis, may then classify the semifinished component carrier 100d selectively as pass, fail or repair.

In a data feedback loop 142, the automatic judgement unit 106 and the additional automatic judgement unit 110 may exchange data so as to further refine the learning process of their artificial intelligence modules.

The resulting classification of each semifinished component carrier 100a-100d may be stored in a database 144. For instance, action control unit 112 (which may also comprise one or more processors) may laminate and pattern further electrically insulating layer structures and electrically conductive layer structures on top of the panel 102 shown on the right-hand side of Figure 1. The procedure of classifying said further layer structures (for instance traces 108) on a surface of such a further processed panel 102 may then undergo again the procedure described referring to Figure 1.

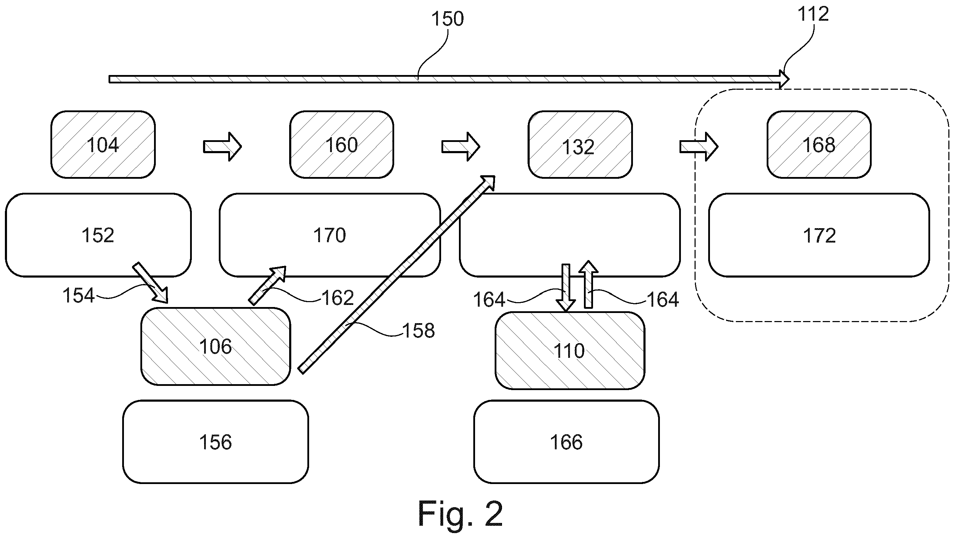

**Figure 2** illustrates a flowchart of a semiautomatic method of manufacturing component carriers 100 according to an exemplary embodiment of the invention.

In Figure 2, a physical product flow or processing path is denoted with reference numeral 150. As described referring to Figure 1, the semifinished component carriers 100 of the panel 102 undergo an automatic optical inspection in automatic optical inspection unit 104. Here, a two-dimensional grey image may be captured, and this may be used for the automated defect inspection. The latter process is indicated schematically by reference numeral 152 in Figure 2. Thereafter, a data analysis flow 154 of the result of the automatic optical inspection is forwarded to first artificial intelligence based working station, i.e. automatic judgement unit 106. As indicated with reference numeral 156, automatic judgement unit 106 carries defect image verification. For instance, a proposal made by the automatic optical inspection unit 104 may be verified (for instance faults, shape, not sure, or scrap).

A further data analysis flow 158 then logically connects automatic judgement unit 106 with automatic optical repair unit 132. Coming back to the processing of the panel 102 with the semifinished component carriers 100, the panel 102 may undergo, after the automatic optical inspection by automatic optical inspection unit 104, a manual verification process, see block 160. As can be taken from reference numeral 162, the data analysis flow from the automatic judgement unit 106 not only logically connects with automatic repair unit 132, but also with manual verification process unit 162. During the manual verification process, a video and an UV (ultraviolet) image of the panel 102 may be captured, and a verification and classification may be carried out, for instance scrap. In the automatic optical repair unit 132, shaping and repairing of one or more semifinished component carriers 100 of panel 102 may be carried out. Video and ultraviolet image data may be used for this purpose. A previous classification may be verified or a semifinished component carrier 100 may be classified as scrap.

As shown in Figure 2 as well, a data communication is possible, along a bidirectional data analysis flow 164 between the automated optical repair unit 132 and additional automatic judgment unit 110. As shown by a block 166, data analysis corresponding to block 156 may be carried out.

As shown by block 168, the described procedure may be followed by an optional manual verification process. The data analysis made in a block 170 in the manual verification process may be repeated, see block 172.

Thus, the embodiment of Figure 2 shows a semi-automated artificial intelligence-based monitoring and inspection process of an exemplary embodiment of the invention.

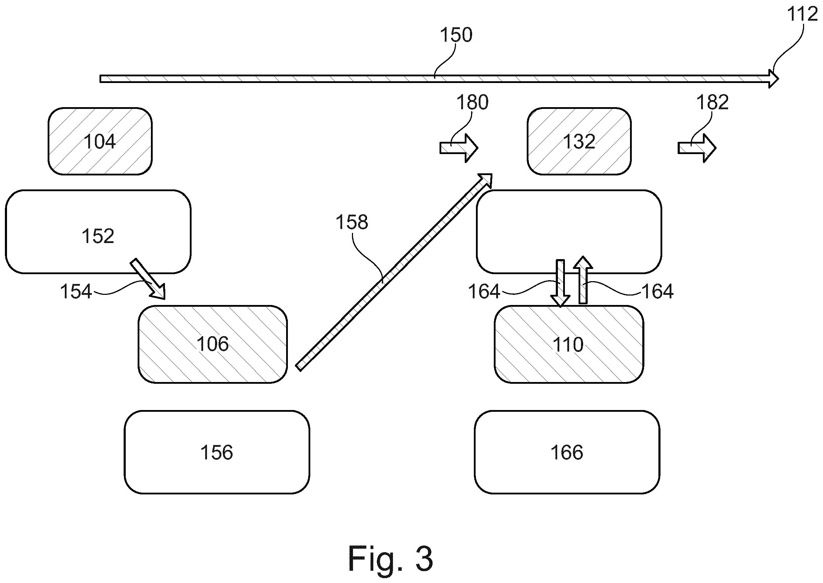

**Figure 3** illustrates a flowchart of a fully automatic method of manufacturing component carriers 100 according to an exemplary embodiment of the invention.

A difference between the embodiment of Figure 2 and the embodiment of Figure 3 is that, in the embodiment of Figure 3, a fully AI (artificial intelligence) based optical inspection and repair system is provided. The automation process is continuous, as indicated by arrows 180, 182.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. A method of manufacturing component carriers (100), wherein the method comprises:
supplying a panel (102), comprising a plurality of semifinished component carriers (100), to an automatic optical inspection unit (104) for automatic optical inspection by comparison of a data set indicative of an actual image of a respective semifinished component carrier (100) with a data set indicative of a reference image;
forwarding the inspected panel (102) to an automatic judgment unit (106) for carrying out a quality classification of the semifinished component carriers (100), based on a result of the automatic optical inspection, by applying artificial intelligence; and
taking an action based on the quality classification.

2. The method according to claim 1, wherein the method comprises taking the action of continuing manufacturing the component carriers (100) without intervening process steps.

3. The method according to claim 2, comprising at least one of the following features:
wherein the method comprises taking the action of continuing manufacturing the component carriers (100) without intervening process steps when the quality classification indicates no defect of a respective semifinished component carrier (100);
wherein the method comprises taking the action of continuing manufacturing the component carriers (100) without intervening process steps when the quality classification indicates an unrepairable defect of a respective semifinished component carrier (100).

4. The method according to any of claims 1 to 3, wherein the method comprises at least one of the following features:
wherein the method comprises taking the action of repairing a respective semifinished component carrier (100) when the quality classification indicates a repairable defect of a respective semifinished component carrier (100), in particular wherein the repairing comprises at least one of the group consisting of separating erroneously connected electrically conductive traces (108), connecting erroneously disconnected electrically conductive traces (108), adding solder material to or removing solder material from a defective solder structure, and repair of a defective core (110);
wherein the method comprises taking the action of repairing a respective semifinished component carrier (100) on basis of a data set indicative of a three-dimensional image of the semifinished component carrier (100) or the panel (102);
wherein the method comprises carrying out the quality classification by classifying a respective individual semifinished component carrier (100) or an entire panel (102) as pass;
wherein the method comprises carrying out the quality classification by classifying a respective individual semifinished component carrier (100) or an entire panel (102) as fail;
wherein the method comprises carrying out the quality classification by classifying a respective individual semifinished component carrier (100) or an entire panel (102) as repairable or to be repaired;
wherein the method comprises carrying out the quality classification by indicating a type of defect among a number of predefined types of defect;
wherein the method comprises carrying out the automatic optical inspection based on a data set indicative of a two-dimensional image of the entire panel (102) or a respective individual semifinished component carrier (100);
wherein the method comprises carrying out the automatic judgment based on a data set indicative of a three-dimensional image of the entire panel (102) or a respective individual semifinished component carrier (100).

5. The method according to any of claims 1 to 4, wherein the method is carried out completely without involving a human operator.

6. The method according to any of claims 1 to 5, wherein the method comprises, when the automatic judgment unit (106) is incapable of performing a quality classification, carrying out a further analysis, in particular wherein the method comprises carrying out the further analysis by an additional automatic judgment unit (110) applying artificial intelligence.

7. The method according to claim 6, wherein the method comprises exchanging data between the automatic judgment unit (106) and the additional automatic judgment unit (110) for learning, in particular in forward and/or backward direction.

8. The method according to claim 6 or 7, wherein the method comprises carrying out the further analysis based on a data set indicative of a three-dimensional image of a respective individual semifinished component carrier (100) or the entire panel (102).

9. The method according to any of claims 1 to 8, wherein the method comprises applying the artificial intelligence in the automatic judgment unit (106) by learning based on historical human-based judgments, in particular under consideration of a comparison of judgments of the automatic judgment unit (106) with human-based judgments.

10. The method according to any of claims 1 to 9, wherein the method comprises at least one of the following features:
wherein the method comprises marking, in particular laser marking, a respective semifinished component carrier (100) or an entire panel (102) based on the quality classification;
wherein the method comprises carrying out the automatic optical inspection during front-end processing of the semifinished component carriers (100) on panel level.

11. The method according to any of claims 1 to 10, wherein the method comprises carrying out the automatic optical inspection and the quality classification after patterning a metal layer for forming electrically conductive traces (108) of the semifinished component carriers (100) or the entire panel (102) for assessing a quality of the formed traces (108).

12. An apparatus (120) for handling a panel (102) during manufacturing component carriers (100), wherein the apparatus (120) comprises:
an automatic optical inspection unit (104) configured for carrying out an automatic optical inspection of the panel (102), comprising a plurality of semifinished component carriers (100), by comparison of a data set indicative of an actual image of a respective semifinished component carrier (100) with a data set indicative of a reference image;
an automatic judgment unit (106) configured for subsequently carrying out a quality classification of the semifinished component carriers (100), based on a result of the automatic optical inspection, by applying artificial intelligence; and
an action control unit (112) configured for taking an action based on the quality classification.

13. The apparatus (120) according to claim 12, wherein the apparatus (120) is configured to carry out or control a method according to any of claims 1 to 11.

14. A computer-readable medium, in which a computer program of manufacturing component carriers (100) is stored, which computer program, when being executed by one or a plurality of processors (104, 106, 110, 112), is adapted to carry out or control a method according to any of claims 1 to 11.

15. A program element of manufacturing component carriers (100), which program element, when being executed by one or a plurality of processors (104, 106, 110, 112), is adapted to carry out or control a method according to any of claims 1 to 11.
